# NEW EUROPEAN PATENT SPECIFICATION

(11) **EP 0 425 900 B2**
(45) Date of publication and mention of the opposition decision: **06.03.2002**
(45) Mention of the grant of the patent: 24.01.1996
(21) Application number: 90119934.9
(22) Date of filing: 17.10.1990
(51) Int. Cl.: C08J 7/06, C23C 14/20, C08J 7/04

(54) **Molded synthetic resin articles having thin metal film and production process thereof**
Kunstharzformkörper mit einer dünnen Metallschicht und Verfahren zu seiner Herstellung
Article moulé en résine synthétique portant un film métallique amincé et procédé pour sa fabrication

(30) Priority: 17.10.1989 JP 26820489
(43) Date of publication of application: 08.05.1991
(73) Proprietor: YKK CORPORATION, Chiyoda-ku, Tokyo (JP)
(72) Inventor: Yamaguchi, Yoshiharu, Namerikawa-shi, Toyama (JP); Funakawa, Shigeru, Shimoniikawa-gun, Toyama (JP)
(74) Representative: Patentanwälte Leinweber & Zimmermann

(56) References cited:
- GB-A- 1 157 825
- GB-A- 1 190 480
- GB-A- 2 210 899
- GB-A- 2 220 590
- US-A- 4 268 570

## Description

The present invention relates to molded synthetic resin articles with a thin metal film formed on surfaces thereof, as specified in the precharacterizing portion of claim 1 said film having surface gloss inherent to metal and excellent adhesion, and also to a production process thereof, as specified in claim 7.

Conventional molded synthetic resin articles having a thin metal film on surfaces thereof include, for example, those obtained by forming a metallic coating layer on surfaces of base bodies molded from a synthetic resin by vapor-phase deposition and then providing a topcoat layer on a surface of the metallic coating layer and those produced by forming an undercoat layer having adhesive force on surfaces of base bodies molded from a synthetic resin, providing a metallic coating layer on a surface of the undercoat layer and then forming a topcoat layer on a surface of the metallic coating layer (see U.S. Patent No. 5035 029, filed March 14, 1990).

The former molded synthetic resin articles have surface gloss inherent to metal as long as their base bodies are formed by extrusion, but when their base bodies have been formed by injection molding it is difficult to obtain molded synthetic resin articles having surface gloss inherent to metal. When a base body is formed from a synthetic resin using an extruder means or the like as in the case of a resin-made wire element for slide fasteners, the surface of the base body is formed as flat as 0.1 µm or less in terms of surface roughness due to its processing procedure. By processing it through a further step such as a stretching step, the surface roughness of the base body can be reduced further. Accordingly, when a metallic coating layer is formed on the surface, no irregular reflection of light takes place on the outer surface of the metallic coating layer owing to the flat surface of the base body so that surface gloss inherent to the metal is provided. In contrast, in the case of a synthetic resin product formed by injection molding, the current situation is that the surface of the synthetic resin product becomes as rough as 0.1 µm or more in terms of surface roughness because of its molding process. The roughness of the base body therefore appears even on the outer surface of the metallic coating layer. As a result, light is subjected to irregular reflection on the rough surface so that the surface has a dark and dull color as if it is frosted or matted. It was hence difficult to obtain molded synthetic resin articles having a surface gloss inherent to a metal. It may be contemplated of increasing the thickness of the metallic coating layer so that the surface of the metallic coating layer can be formed flat without being affected by the roughness of the surface of the base body. To achieve this, it is indispensable to make the metallic coating layer considerably thicker. This approach therefore involves problems in the adhesion to the resin-made base body and also in economy.

The latter molded synthetic resin articles in the prior art are accompanied by the problem that the metal coating layers are prone to separation along with the adhesive from the associated base bodies. When an adhesive is coated on a base body made of a synthetic resin, the attraction developed by intermolecular force between the base body made of the synthetic resin and the adhesive is generally defined as the adhesive force therebetween. It is therefore known that a weak adhesive force can only be obtained when a base body made of a non-polar or substantially non-polar synthetic resin is coated with an adhesive which is also non-polar or substantially non-polar. Accordingly, separation tends to occur between the surface of the base body made of the synthetic resin and the adhesive.

From US patent 4,268,570, from which the invention starts, a molded synthetic resin body having a thin coating on a surface thereof, said thin coating comprising an undercoat layer, an outer vapor-deposited metal layer formed by vapor-phase deposition and a transparent or translucent topcoat layer, all said layers being successively provided on said surface of said body in the order set out above, is known. Said body corresponds to the latter prior art as described above and, further, it is made of a special polymer mixture, said mixture being the main subject matter described in said document.

From the UK patent application 2 210 899 A a metallized plastic film with a low permeability to gases, moisture and light and comprising a thermoplastic film metallized on one face, overcoated on said metal face with a thin plastic coating and remetallized on the coated face, is known. Said document concentrates on the problem of gas permeability and on the stiffness of multilayer films for packaging.

It is therefore the principal object of the present invention to overcome the above-described problems of the related art. Described specifically, an object of the present invention is to provide a molded synthetic resin article with a thin metal film formed on a surface thereof, said thin metal film having good adhesion and surface gloss inherent to metal. Another object of the present invention is to provide a process for the production of the above molded synthetic article.

According to the present invention, there is provided a molded synthetic resin body as specified in claim 1 the order set out above.

According to the present invention, there is also provided a process for the production of a molded synthetic resin body as specified in claim 7.

In the present invention, owing to the alternate arrangement of the base body made of the non-polar or substantially non-polar synthetic resin, the undercoat layer and the topcoat layer with the vapor-deposited polar metal layers, excellent adhesion is provided between each adjacent layers. Further, any surface roughness of the base body is absorbed by the undercoat layer so that the outer surface of the undercoat layer can be formed flat. The second vapor-deposited metal layer is provided on the flat surface of the undercoat layer, so that a molded synthetic resin article having surface gloss inherent to the metal is obtained without irregular reflection of light on the surface of the second vapor-deposited metal layer. This invention therefore shows excellent advantageous effects from the practical viewpoint. Especially, the thin metal film can remain free from separation over a long time even in the case of a product being subjected to repeated mechanical contacts, so that a surface gloss inherent to a metal can be retained.

Further, the production process of the present invention can easily produce such excellent molded synthetic resin articles.
FIG. 1 is a simplified schematic vertical cross-section of a molded article according to the present invention, which illustrates the arrangement of the individual layers;
FIG. 2 is a schematic diagram of a vapor-phase deposition apparatus suitable for use in the practice of the production process of the present invention;
FIG. 3(a) is a front view of a buckle assembly to which the present invention is applied by way of example;
FIG. 3 (b) is a front view of a male part;
FIG. 4(a) is a plan view of a slide fastener to which the present invention is applied by way of example; and
FIG. 4(b) is a vertical cross-section of a fastener element to which the present invention has been applied, which shows the arrangement of the individual layers.

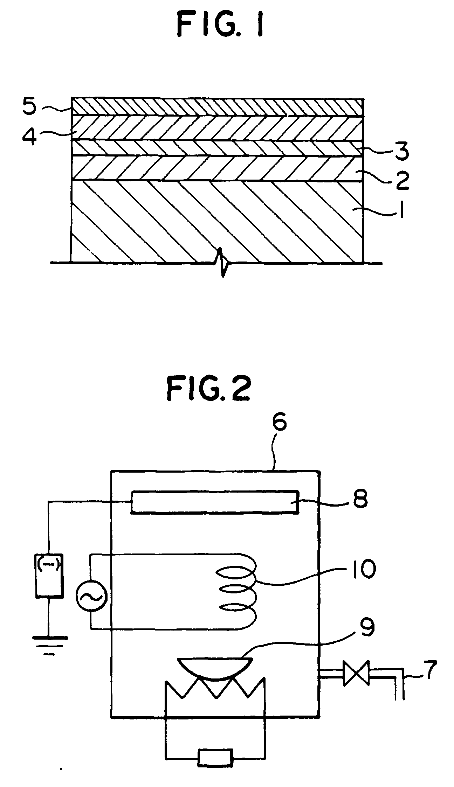

FIG. 1 is a vertical cross-section showing the arrangement of layers in the present invention. FIG. 1 shows a base body 1, a first vapor-deposited metal layer 2, an undercoat layer 3, a second vapor-deposited metal layer 4, and a topcoat layer 5.

The base body 1 of the present invention is made of a synthetic resin such as a polyester, a polyamide, polyethylene, polypropylene, a polyacetal or a polycarbonate. On a surface of the base body 1, a metal such as aluminum, chromium, nickel, stainless steel, gold, silver or copper or brass or an alloy thereof is caused to deposit in the form of a thin film by means of vapor-phase deposition such as vacuum deposition, ion plating, sputtering or chemical vapor deposition (CVD), so that the vapor-deposited metal layer 2 is formed.

Coating formulations employed for the formation of the undercoat layer 3 and the topcoat layer 5 can be composed of a heat-reactive, electron-radiationcuring or ultraviolet-curing synthetic resin such as an acrylate, urethane, polyester, urea-melamine, epoxy, aminoalkyd, polyisocyanate or alkyl titanate resin; and nitrocellulose. The undercoating formulation is sprayed onto the first vapor-deposited metal layer 2, whereby the undercoat 3 is formed with excellent adhesion to the first vapor-deposited metal layer 2. On the other hand, the topcoating formulation is sprayed onto the second vapor-deposited metal layer 4 and then dried, so that the topcoat layer 5 is formed with excellent metallic gloss and high adhesion and washing resistance. The topcoat layer 5 is required to be transparent or translucent so that the color tone of the underlying second vapor-deposited metal layer 4 is visible therethrough. The topcoat layer 5 may be tinged in such a desired color that does not adversely affect the observation of the color tone of the underlying second vapor-deposited metal layer 4 through the topcoat layer 5. For example, application of a topcoat layer 5 tinged in a yellow color over an vapor-deposited aluminum layer 4 presenting a silver gloss makes it possible to obtain a molded synthetic resin article having a gloss inherent to a metal of a gold color. Further, application of a green-tinged topcoat layer 5 over a vapor-deposited aluminum layer 4 makes it possible to produce a gloss inherent to a green metal. By covering vapor-deposited metal layers 4 having a gloss of various base colors with topcoat layers 5 tinged in various colors which do not impair the observation of the base colors of the underlying vapor-deposited metal layers 4, decorated articles having a gloss inherent to metals corresponding to the colors can be obtained.

The vapor-phase evaporation means useful in the practice of the present invention will next be described, taking ion plating by way of example. As shown in FIG. 2, an inert gas, e.g., argon gas is introduced into a vacuum vessel 6 through a gas feed line 7. A molded base body made of a synthetic resin is provided as a base material 8, either as is or after forming an undercoat layer on a surface thereof. In the vacuum vessel 6, the base material 8 is arranged as a cathode in opposition to an evaporation source 9 made of a desired metal material. A voltage is then applied across the base material 8 and the evaporation source 9, whereby the desired metal material is caused to evaporate as atoms, molecules or clusters. They are then ionized by a high-frequency electric field which has been produced by applying a high voltage across a high-frequency coil 10 disposed between the base material 8 and the evaporation source 9. A surface of the base material 8 is hence exposed to the resulting high-energy ions so that a vapor-deposited metal layer is formed on the surface of the base material 8. By accelerating the high-energy ions by the high-frequency electric field and causing them to collide against the surface of the base material, the surface of the base material is heated to a super high temperature at the collision points owing to the large energy of the ion particles so that the particles are allowed to firmly bond to the surface of the base material. In addition, by applying a large energy to the atoms of the vapor-deposited metal layer of the desired metal material through ion implantation by ion bombardment and the resulting mixing, the lattice atoms of the vapor-deposited metal layer undergo violent vibrations. As a result, high lattice defects are formed in the surface and interface so that the vapor-deposited metal layer can be formed with good adhesion and high strength. By removing any oil layers and impurities on the surface of the base material in accordance with ultrasonic cleaning or etching, an active and clean resin surface can be obtained. Ultrasonic cleaning or etching can therefore eliminate any detrimental effect to the adhesion of the vapor-deposited metal layer.

When aluminum is used as the evaporation source in the above description, the resulting vapor-deposited aluminum layer having a thickness, for example, not greater than 0.1 µm has a grayish white color and cannot present a surface having surface gloss inherent to the metal if the surface roughness of the resin-made base body exceeds 0.1 µm. However, by coating the deposited aluminum layer with an undercoating formulation having good adhesion to aluminum and composed of, for example, a polyesterpolyol as a principal component and a polyisocyanate as a curing agent and then forming a vapor-deposited aluminum layer, a silver color having a high gloss inherent to the metal can be obtained. Further, by coating a topcoat formulation to protect the vapor-deposited metal layer, a molded synthetic resin article having excellent abrasion resistance and adhesion and surface gloss inherent to a metal can be obtained.

In the formation of the vapor deposited metal layer by the above-mentioned vapor deposition procedure, metal particles of a desired metal material are individually deposited onto the surface of the substrate made of synthetic resin or the surface of the undercoat layer by bombarding high-energy metal particles onto the resin surface of them and heating the bombarded points due to the large energy of the individual metal particles. The undercoat formulation and the topcoat formulation are selected from coating materials having a good adhesion to the vapor-deposited polar metal layer and are applied onto the vapor-deposited metal layer. In such procedures, there can be obtained superior molded synthetic resin articles coated with a thin layer having a good adhesion.

The present invention will hereinafter be described specifically by the following example.

### Example

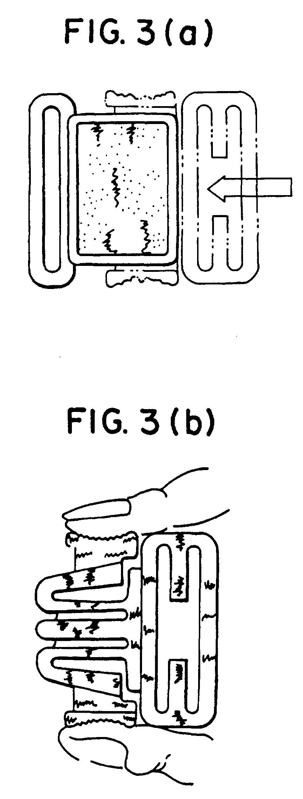

An injection molded product of a polyacetal polymer as a base body (surface roughness:≥ 0.1 µm) was subjected to ultrasonic cleaning with Flon (registered trademark). A vapor-deposited aluminum layer having a thickness of 0.05 to 0.1 µm was formed over the entire surface of the base body by high-frequency ion plating. Next, an undercoating formulation composed of a solvent-type polyester, a solvent-type polyisocyanate and thinner was sprayed at the ratio of 100 : 30 : 20 onto the vapor-deposited aluminum layer, said polyester and polyisocyanate both having a good adhesion to aluminum. The undercoating formulation thus sprayed was dried at 120 °C for 90 minutes, whereby an undercoat layer was formed. In much the same way as described above, another aluminum film having a thickness of 0.05 to 0.1 µm was then formed over the entire surface of the undercoat layer by high-frequency ion plating. A topcoating formulation composed of a solvent-type polyester, a solvent-type polyisocyanate and thinner at the ratio of 100 : 5 : 50, said polyester and polyisocyanate having good adhesion to aluminum, was thereafter sprayed, followed by drying at 65 °C for 80 minutes to form a topcoat layer. The resultant product was then left for an appropriate period of time until curing proceeded to completion, whereby a molded synthetic resin article was obtained. The surface of the molded synthetic resin article thus obtained was cut at intervals of 1 mm by a knife to form a grid pattern consisting of 100 squares. A forced test was then conducted by firmly applying a JIS cellophane adhesive tape onto the squares and pulling it off. The remaining squares per 100 squares in total were counted. For the sake of comparison, a similar forced test was also conducted on each of injection-molded articles, one obtained by successively forming an undercoat layer, a vapor-deposited metal layer and a topcoat layer on an injection molded product of a polyacetal polymer in a similar manner as described above (conventional product: Comparative Example 1) and the other obtained by successively forming a vapor-deposited metal layer and a topcoat layer on an injection molded product of a polyacetal polymer in a similar manner as described above (Comparative Example 2). In addition, an actual service test was also conducted using a buckle assembly constructed of a female part having a tongue-receiving slot and a male part having a tongue, as shown in FIGS. 3(a) and 3(b). The film is susceptible to separation around the tongue-receiving slot and tongue of the buckle due to mechanical contacts which take place while the tongue is repeatedly inserted into and pulled out of the tongue-receiving slot. High adhesion is therefore most required around the tongue-receiving slot and the tongue, and in these parts, the insertion and subsequent pull-out of the tongue were repeated 200 times in the actual service test.

The results of the above forced test and actual service test and the surface gloss of the thin metal films formed on the molded synthetic resin articles are shown in Table 1.

**Table 1**

| | Forced test | Service test | Surface gloss |
|---|---|---|---|
| Ex. | No separation | No separation | Good |
| Comp. Ex. 1 | Separated | Separated after one insertion and pull-out | Good |
| Comp. Ex. 2 | No separation | No separation | No gloss Grayish white |

As is envisaged from the foregoing description, each molded synthetic resin article of the present invention, which has a thin metal film on a surface thereof, is excellent in the adhesion of the film and presents a surface gloss inherent to the metal. When the present invention is applied to the buckle assembly shown in FIGS. 3(a) and 3(b) and molded, for example, from an acetal resin, substantially no film separation takes place at latching parts thereof even after repeated engagement and disengagement of fastening parts. The buckle assembly can therefore always present a good external appearance.

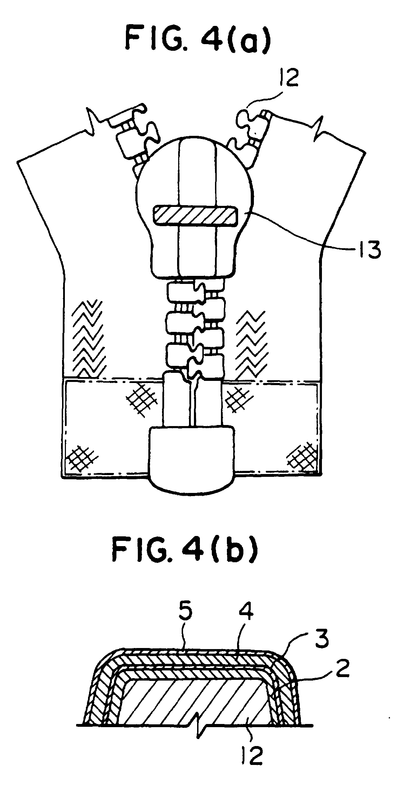

Further, by applying the present invention, for example, to fastener elements 12 of a slide fastener 11 shown in FIG. 4(a), said elements being made of an acetal resin by way of example, as illustrated in FIG. 4(b), a product having metallic decoration can be obtained. The thin metal films do not separate from the surfaces of the fastener elements due to the slide of a slider 13 or engagements and disengagements of the fastener elements themselves. The slide fastener can therefore retain a good external appearance.

## Claims

1. A molded synthetic resin body (1) having a roughness of 0,1 µm or greater and being covered by a thin coating on a surface thereof, said thin coating comprising an undercoat layer (3), an outer vapor-deposited metal layer (4) formed by vapor-phase deposition and a transparent or translucent topcoat layer (5), all said layers being successively provided on said surface of said body (1) in the order set out above; ***characterized by** an* inner vapor-deposited metal layer (2) formed by vapor-phase deposition between said body (1) and said undercoat (3).

2. A molded synthetic body (1) according to claim 1, wherein said vapor-deposited metal layers (2, 4) consist of aluminum, chromium, nickel, stainless steel, gold, silver or copper or brass or an alloy thereof.

3. A molded synthetic body (1) according to one of the preceding claims, wherein said inner vapor-deposited metal layer (2) and said outer vapor-deposited metal layer (4) have a thickness of 0.05 to 0.1 µm each.

4. A molded synthetic resin body (1) according to one of the preceding claims, wherein said undercoat layer (3) and/or said topcoat layer (5) are composed of a heat-reactive, electron-radiation-curing or ultraviolet-curing synthetic resin such as an acrylate, urethane, polyester, urea-melamine epoxy, aminoalkyd, polyisocyanate or alkyl titanate resin; or nitrocellulose.

5. A molded synthetic resin body (1) according to one of the preceding claims and made of a polymer selected from polyester, polyamide, polyethylene, polypropylene, polyacetal or polycarbonate.

6. A molded synthetic resin body (1) according to one of the preceding claims and being a part of a buckle assembly or being a fastener element (12) of a slide fastener (11).

7. A process for the production of a molded synthetic resin body (1) having a roughness of 0,1 µm or greater and being covered by a thin coating on a surface thereof which comprises:
forming an inner vapor-deposited metal layer (2) of a desired metallic material on said surface of said body by vapor-phase deposition;
applying on a surface of said inner vapor-deposited metal layer (2) an undercoating formulation having an adhesive force to said inner vapor-deposited metal layer (2), whereby an undercoat layer (3) is formed;
forming an outer vapor-deposited metal layer (4) of a deposited metallic material on a surface of said undercoat layer (3) by vapor-phase deposition; and
applying on a surface of said outer vapor-deposited metal layer (4) a transparent or translucent topcoating formulation having an adhesive force to said second vapor-deposited metal layer (4), whereby a topcoat layer (5) is formed.

8. A process according to claim 7, wherein said inner vapor-deposited metal layer (2) and/or said outer vapor-deposited metal layer (4) are vapor-deposited by a means of vacuum deposition, ion plating, sputtering or chemical vapor deposition (CVD).

9. A process according to claim 7 or 8 and further comprising the step of injection molding of said molded synthetic resin bodv (1).

## Patentansprüche

1. Kunstharzformkörper (1) mit einer Rauhigkeit von 0,1 µm oder mehr, der auf einer Oberfläche bedeckt ist durch eine dünne Beschichtung, wobei die dünne Beschichtung eine Unterschicht (3), eine durch Gasphasenabscheidung gebildete äußere Gasphasenabscheidungsmetallschicht (4) und eine durchsichtige oder durchscheinende Oberschicht (5) aufweist, wobei alle diese Schichten in der obigen Reihenfolge aufeinanderfolgend auf der Oberfläche des Körpers (1) vorgesehen sind; **gekennzeichnet durch** eine **durch** Gasphasenabscheidung zwischen dem Körper (1) und der Unterschicht (3) gebildete innere Gasphasenabscheidungsmetallschicht (2).

2. Kunstharzformkörper (1) nach Anspruch 1, bei dem die Gasphasenabscheidungsmetallschichten (2, 4) aus Aluminium, Chrom, Nickel, Edelstahl, Gold, Silber oder Kupfer oder Messing oder einer Legierung daraus bestehen.

3. Kunstharzformkörper (1) nach einem der vorstehenden Ansprüche, bei dem die innere Gasphasenabscheidungsmetallschicht (2) und die äußere Gasphasenabscheidungsmetallschicht (4) jeweils eine Dicke von 0,05 bis 0,1 µm aufweisen.

4. Kunstharzformkörper (1) nach einem der vorstehenden Ansprüche, bei dem die Unterschicht (3) und/oder die Oberschicht (5) aus einem wärmereaktiven, elektronenstrahlungsaushärtenden oder ultraviolettaushärtenden Kunstharz aufgebaut sind, etwa einem Acrylat-, Urethan-, Polyester-, Urea-Melamin-Epoxid-, Aminoalkyd-, Polyisocyanat- oder Alkyltitanat-Harz; oder Nitrozellulose.

5. Kunstharzformkörper (1) nach einem der vorstehenden Ansprüche, hergestellt aus einem Polymer, das ausgewählt ist aus: Polyester, Polyamid, Polyethylen, Polypropylen, Polyacetal oder Polycarbonat.

6. Kunstharzformkörper (1) nach einem der vorstehenden Ansprüche, der Teil eines Schließenaufbaus oder ein Verschlußglied (12) eines Reißverschlusses (11) ist.

7. Verfahren zur Herstellung eines Kunstharzformkörpers (1) mit einer Rauhigkeit von 0,1 µm oder mehr, der auf einer Oberfläche bedeckt ist durch einer dünnen Beschichtung, wobei das Verfahren beinhaltet:
Bilden einer inneren Gasphasenabscheidungsmetallschicht (2) aus einem erwünschten Metallmaterial auf der Oberfläche des Körpers durch Gasphasenabscheidung;
auf eine Oberfläche der inneren Gasphasenabscheidungsmetallschicht (2) Aufbringen eines Unterschichtansatzes, der bezüglich der inneren Gasphasenabscheidungsmetallschicht (2) eine Haftkraft aufweist, wodurch eine Unterschicht (3) gebildet wird;
Bilden einer äußeren Gasphasenabscheidungsmetallschicht (4) aus einem erwünschten Metallmaterial auf einer Oberfläche der Unterschicht (3) durch Gasphasenabscheidung; und
auf eine Oberfläche der äußeren Gasphasenabscheidungsmetallschicht (4) Aufbringen eines durchsichtigen oder durchscheinenden Oberschichtansatzes, der bezüglich der zweiten Gasphasenabscheidungsmetallschicht (4) eine Haftkraft aufweist, wodurch eine Oberschicht (5) gebildet wird.

8. Verfahren nach Anspruch 7, bei dem die innere Gasphasenabscheidungsmetallschicht (2) und/oder die äußere Gasphasenabscheidungsmetallschicht (4) mittels Abscheidung im Vakuum, Ion-Plating, Sputtern oder chemischer Gasphasenabscheidung (CVD) Gasphasen-abgeschieden werden.

9. Verfahren nach Anspruch 7 oder 8, das ferner den Schritt des Spritzens des Kunstharzformkörpers (1) beinhaltet.

## Revendications

1. Objet moulé (1) en résine de synthèse présentant une rugosité supérieure ou égale à 0,1 µm et couvert d'un mince revêtement sur sa surface, ledit mince revêtement comprenant une sous-couche (3), une couche métallique extérieure (4) formée par dépôt à partir d'une phase gazeuse et une surcouche (5) transparente ou translucide, toutes lesdites couches étant placées successivement sur ladite surface dudit objet (1) dans l'ordre énoncé ci-dessus,
**caractérisé par** une couche métallique interne (2) formée par dépôt à partir d'une phase gazeuse entre ledit objet (1) et ladite sous-couche (3).

2. Objet moulé (1) en résine de synthèse selon la revendication 1, dans lequel lesdites couches métalliques (2, 4) formées par dépôt à partir d'une phase gazeuse sont de l'aluminium, du chrome, du nickel, de l'acier inoxydable, de l'or, de l'argent, du cuivre ou du laiton ou un alliage de ceux-ci.

3. Objet moulé (1) en résine de synthèse selon l'une des précédentes revendications, dans lequel ladite couche métallique interne (2) formée par dépôt à partir d'une phase gazeuse et ladite couche métallique externe (4) formée par dépôt à partir d'une phase gazeuse ont chacune une épaisseur valant de 0,05 à 0,1 µm.

4. Objet moulé (1) en résine de synthèse selon l'une des précédentes revendications, dans lequel ladite sous-couche (3) et/ou ladite surcouche (5) sont faites d'une résine de synthèse thermoréactive, durcissant sous l'effet d'un rayonnement électronique ou durcissant sous l'effet d'un rayonnement ultraviolet comme une résine d'acrylate, d'uréthane, polyester, d'urée-mélamine, époxy, amino-alkyde, polyisocyanate ou de titanate d'alkyle, ou comme de la nitro-cellulose.

5. Objet moulé (1) en résine de synthèse selon l'une des précédentes revendications, fait d'un polymère choisi parmi les polyesters, les polyamides, les polyéthylènes, les polypropylènes, les polyacétals ou les polycarbonates.

6. Objet moulé (1) en résine de synthèse selon l'une des précédentes revendications, faisant partie d'un ensemble de boucle ou constituant un élément d'accouplement (12) d'une fermeture à glissière (11).

7. Procédé de fabrication d'un objet moulé (1) en résine de synthèse présentant une rugosité supérieure ou égale à 0,1 µm et couvert d'un mince revêtement sur sa surface, qui comprend :
- la formation d'une couche métallique interne (2) par dépôt à partir d'une phase gazeuse d'un matériau métallique voulu sur ladite surface dudit objet,
- l'application sur la surface de ladite couche métallique interne (2) formée par dépôt à partir d'une phase gazeuse d'une composition de sous-couche ayant une capacité d'adhérence sur ladite couche métallique interne (2) formée par dépôt à partir d'une phase gazeuse, grâce à quoi est formée une sous-couche (3),
- la formation d'une couche métallique externe (4) par dépôt à partir d'une phase gazeuse d'un matériau métallique voulu sur la surface de ladite sous-couche (3), et
- l'application sur la surface de ladite couche métallique externe (4) formée par dépôt à partir d'une phase gazeuse d'une composition de surcouche, transparente ou translucide, ayant une capacité d'adhérence sur ladite seconde couche métallique (4) formée par dépôt à partir d'une phase gazeuse, grâce à quoi est formée une surcouche (5).

8. Procédé selon la revendication 7, dans lequel ladite couche métallique interne (2) formée par dépôt à partir d'une phase gazeuse et/ou ladite couche métallique externe (4) formée par dépôt à partir d'une phase gazeuse sont déposées à partir d'une phase gazeuse par dépôt sous vide, par placage ionique, par projection ou par dépôt chimique à partir d'une phase gazeuse (CVD).

9. Procédé selon la revendication 7 ou 8, comprenant en outre l'étape de moulage par injection dudit objet moulé (1) en résine de synthèse.
